# EUROPEAN PATENT APPLICATION

(11) **EP 1 432 014 A2**
(43) Date of publication of application: **23.06.2004**
(21) Application number: 03257642.3
(22) Date of filing: 04.12.2003
(51) Int. Cl.: H01L 21/00

(54) **vacuum chamber purging method and apparatus**

(30) Priority: 18.12.2002 US 322211
(71) Applicant: THE BOC GROUP, INC., Murray Hill, New Providence, New Jersey 07974 (US)
(72) Inventor: Tapp, Frederick Leon, Hillsborough, NC 27278 (US); Murphy, Daimhin Paul, San Francisco, CA 94110 (US)
(74) Representative: Booth, Andrew Steven

(57) **Abstract**

A vacuum chamber load lock purging method and apparatus is disclosed. The purging apparatus includes a purging gas diffusion device disposed in a rear portion of a load lock chamber. The purged gas diffusion device is located proximate the vacuum door and distal from the atmospheric door such that the purge gas diffuses towards the atmospheric door during purging. The purging gas diffusion device is porous and permits a purge gas such as nitrogen to purge a load-lock chamber of oxygen or other contaminants from the load lock. The purge gas diffusion device may be tubular and is positioned in the load lock chamber in an offset channel portion in communication with and offset from a through path portion of the load lock chamber, through which a product, such as a semiconductor wafer may proceed without disruption by the diffusion device. The load lock purging system is useful, for example, in a film deposition or other process in which precisely-controlled conditions of pressure and concentration affect the integrity of the process.

## Description

The present invention relates generally to load-lock chambers used in the processing of semiconductor wafers. More specifically, the present invention relates to an apparatus and methodology for purging a load-lock chamber with an inert gas.

In industrial process applications, particularly in the semiconductor field, it is common to utilize a load-lock chamber in order to prevent introduction of ambient air into the processing chamber. The introduction of air contaminants could degrade the quality of the film deposition deposited on semiconductor wafers. The goal is to reduce the introduction of contaminants into the load lock, particularly oxygen and moisture, to prevent such contamination from adversely affecting processing of the semiconductor wafers.

In general, a semiconductor processing system will often include a load-lock chamber, a central handler chamber, and a processing chamber configured together and isolated by pneumatic gate valves. During the process, the load-lock chamber receives a semiconductor wafer. The gas in the load-lock chamber is evacuated and replaced with a gas that will permit a pressure environment to be created, which is generally the same as the process chamber. The gate valve is opened and the wafer is moved from the load-lock chamber to the processing chamber via the central handler. Following processing, the gate valve is opened and the wafer is returned to the load-lock chamber. Then the gate valve is closed and the gas within the load-lock chamber is evacuated and replaced with an inert gas, such as nitrogen, which is used to return the load lock to atmospheric pressure. The inert gas may be used to purge the load-lock chamber while the wafer is being moved into and out of the chamber.

One method of introducing the purge gas to the load-lock chamber is with one or more nozzles. The use of purge gas nozzles produce turbulent flows and eddy regions that results in high concentration of oxygen and moisture within the purged region. The introduction of moisture is particularly troublesome, as it tends to adsorb on the interior surfaces of the chamber. This adsorbed moisture may then be slowly released during the chamber evacuation process, and subsequently transported to the wafer process chamber.

Therefore, it would be desirable to be able to introduce a purge gas into a load-lock chamber while maintaining relatively low oxygen and moisture levels in order to reduce contamination of a semiconductor wafer during a film deposition process.

In one aspect of the invention, a purging apparatus includes a load-lock having a vacuum door and an atmospheric door and defining a load-lock chamber. A purging gas diffusion device is disposed in the load-lock chamber proximate the vacuum door and distal from the atmospheric door. The purging gas diffusion device includes a porous section. The pores in the porous section diffuse the purge gas therethrough in a purge flow that travels through the load-lock chamber in flow direction from the vacuum door to the atmospheric door.

In another aspect of the invention, a method for purging a load lock includes providing a load-lock having a vacuum door and an atmospheric door and defining a load-lock chamber, a purging gas diffusion device disposed in the load-lock chamber proximate the vacuum door and distal from the atmospheric door, the purging gas diffusion device including a plurality of pores. The method includes diffusing purge gas through the pores of the purging gas diffusing device; creating a purge gas flow within the load-lock chamber to remove ambient air and prevent entrainment of air during wafer transport.

The present invention also provides purging apparatus for a load-lock, the apparatus comprising means for diffusing a purge gas through the load-lock, said means comprising a porous section through which the purge gas enters the load-lock.

Various other features, objects and advantages of the present invention will be made apparent from the following detailed description and the drawings.
Prefered features of the present invention will now be described, by way of example only, with reference to the accompanying drawings, in which:-
Fig. 1 is a perspective view of a load lock purging system,
Fig. 2 is a side view of the load lock purging system of Fig. 1;
Fig. 3 is a top schematic view of the load lock purging system;
Fig. 4 is a schematic side section view of the load lock purging system of Fig. 3;
Fig. 4A is a schematic side section view of the load lock purging system of Fig. 3 with the vacuum door removed;
Fig. 5 is a perspective view of an exemplary purging gas diffusion device;
Fig. 6 is another perspective view of the purging gas diffusion device of Fig. 5;
Fig. 7 is a cross-sectional view of the purging gas diffusion device of Fig. 5; and
Fig. 8 is a graph illustrating oxygen concentration data taken from a purge optimization test.

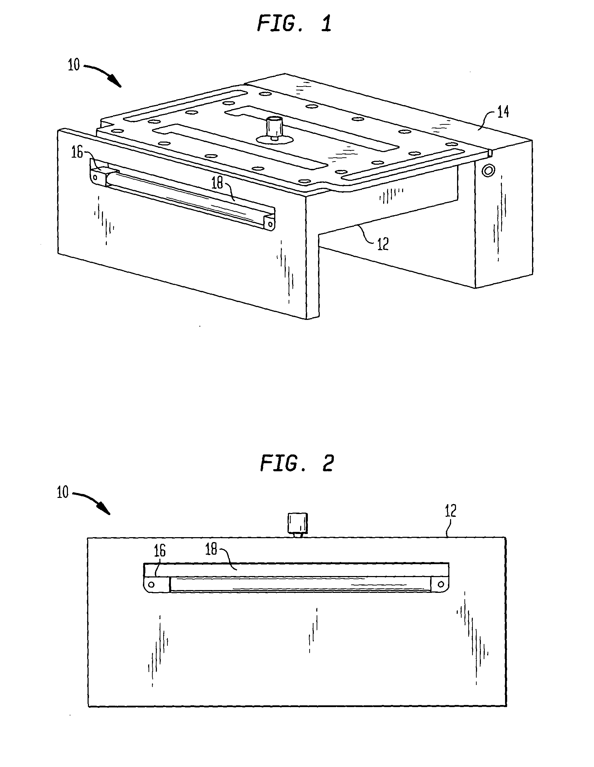

Referring now to Fig. 1, a perspective view of a load lock purging system is shown. The purging apparatus is identified generally by the numeral 10. Purging apparatus 10 includes a load lock 12 which may be used in, for example, a semiconductor wafer film deposition process. The purpose of load lock 12 is to minimize the introduction of ambient air contaminants into the semiconductor tool and to balance pressures to facilitate transport of wafers between the cleanroom and the process chamber. Although load lock 12 may be used in a semiconductor process, it may be used with any process in which air or moisture could degrade the quality of a film deposition, and in which the regulation of air content and moisture concentration is contemplated Purging apparatus 10 includes an atmospheric door 14 which is connected to load lock 12 and can be opened or closed as desired to expose the interior of load lock 12 to the ambient atmosphere. Also connected to load lock 12 is a vacuum door which has been removed to facilitate understanding of the drawing. Fig. 1 shows a load lock chamber 18 partially exposed to show purging gas diffusion device 16 disposed within the load lock chamber 18 and connected to load lock 12. Purging gas diffusion device 16 is located preferably in a horizontal position with respect to the operational position of load lock 12, and purging gas diffusion device 16 is located proximate to the vacuum door and distal from the atmospheric door 14. Load lock 12 may be constructed of any suitable material and aluminum is an example of one such material.

Referring now to Fig. 2, a side view of the load lock purging system of Fig. 1 is shown. As can be seen in this view of purging apparatus 10 (now with both the vacuum door and the atmospheric door removed), the load lock chamber 18 runs the entire length of the purging apparatus 10, and through load lock chamber 18 to facilitate moving, for example, a semiconductor wafer along through load lock chamber 18 of load lock 12 and into, for example, a process chamber. The load lock chamber is capable of having an interior pressure that is substantially equal to a vacuum condition, as during a semiconductor process.

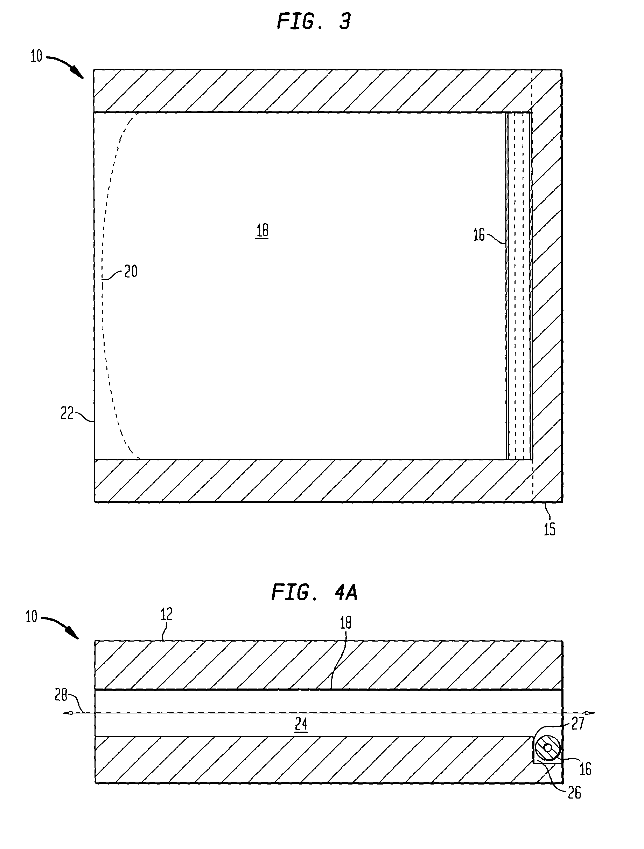

Referring now to Fig. 3, a top schematic view of the load lock purging system 10 is shown. In this figure, vacuum door 15 is shown closed, as would occur during the purging process. In operation, purging gas diffusion device 16 diffuses an inert gas, which preferably includes one of N₂, Ar and He, and more preferably N₂. However, the operation of the present invention is independent of the type of purged gas selected. The diffusion of the purged gas by the purging gas diffusion device 16 produces a purge flow having a purge flow boundary 20. One of the benefits of the present invention is that this purge flow boundary 20 is typically of a laminar flow type. Therefore, the purged gas flows through the entire load lock chamber 18 and purges ambient air via atmospheric door exit 22, since the atmospheric door is opened prior to purging.

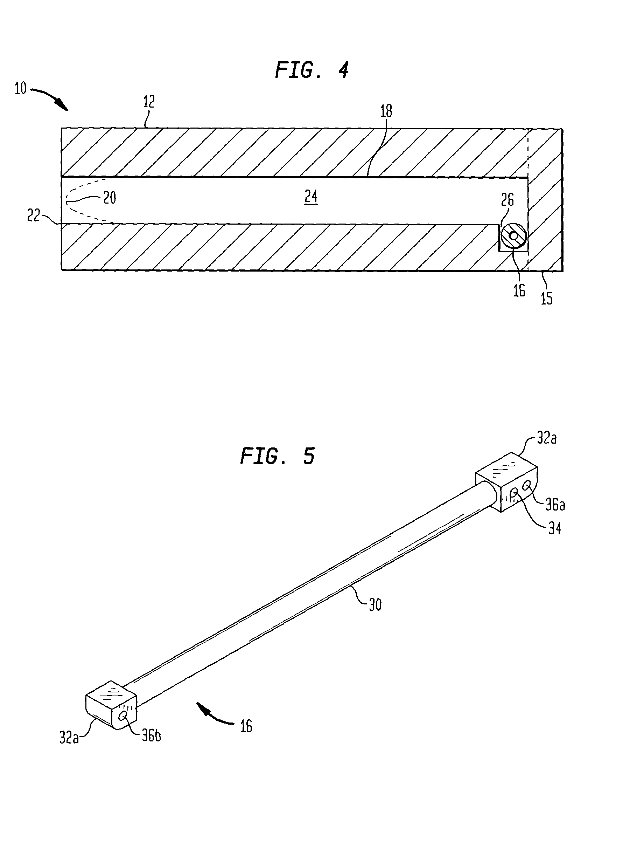

Referring now to Figs. 4 and 4a, schematic side section views of the load lock purging system 10 are shown, with Fig. 4A illustrating Fig. 4 with the vacuum door 15 removed. Here it is illustrated that load lock chamber 18 of load lock 12 includes a through-path portion 24 and an offset channel portion 26, located in the region created by curb 27. It is in this offset channel portion 26 into which purging gas diffusion device 16 is disposed. Preferably, the purging gas diffusion device 16 is placed such that it is substantially in the offset channel portion 26 and does not extend substantially into the through path portion 24. This placement prevents purging gas diffusion device 16 from interfering with, for example, a semiconductor wafer as it travels through-path portion 24 of load lock chamber 18. The placement of purging gas diffusion device 16 is important to prevent obstruction of products passing through the load-lock chamber 18 in general, and particularly through-path portion 24. Again, for orientation purposes, since the purging of load lock chamber 18 occurs in a purging direction from vacuum door 15 to atmospheric door exit 22, purging gas diffusion device 16 is placed such that it is at a rear section of load lock chamber 18 and proximate the vacuum door 15. As purging gas diffusion device 16 diffuses the purge gas therethrough, purge gas proceeds from the offset channel portion 26 and generally along through-path portion 24 in the purging direction, thereby purging load lock chamber 18 with the desired purge gas. As a result, because of the placement of purging gas diffusion device 16 into offset channel portion 26 of load lock chamber 18, a semiconductor wafer or other product may travel along through-path portion 24 along the line indicated by 28 without purging gas diffusion device 16 interfering with the product's progress through load lock chamber 18.

Fig. 5 is a perspective view of an exemplary purging gas diffusion device. Purging gas diffusion device 16 is constructed to receive a flow of purge gas and diffuse it through a porous material of which purging gas diffusion device 16 is constructed. Purge gas diffusion device includes a hollow tubular member or portion 30 for receiving a purge gas and diffusing the purge gas through the pores of the hollow tubular member.

In one embodiment, tubular member 30 is a frit made of 3/16th inch stainless steel and includes a center tubular portion 30 and end portions 32a and 32b, which are connected to tubular portion 30. Although tubular portion 30 is shown as a tube, it is contemplated that other structures having various shapes that permit the flow of gas therethrough may be suitably employed. End portion 32a defines a purge gas inlet 34 as well as a mounting channel 36a. End portion 32b similarly includes a mounting channel 36b such that purging gas diffusion device 16 may be secured to the load lock 12 (of Fig. 1).

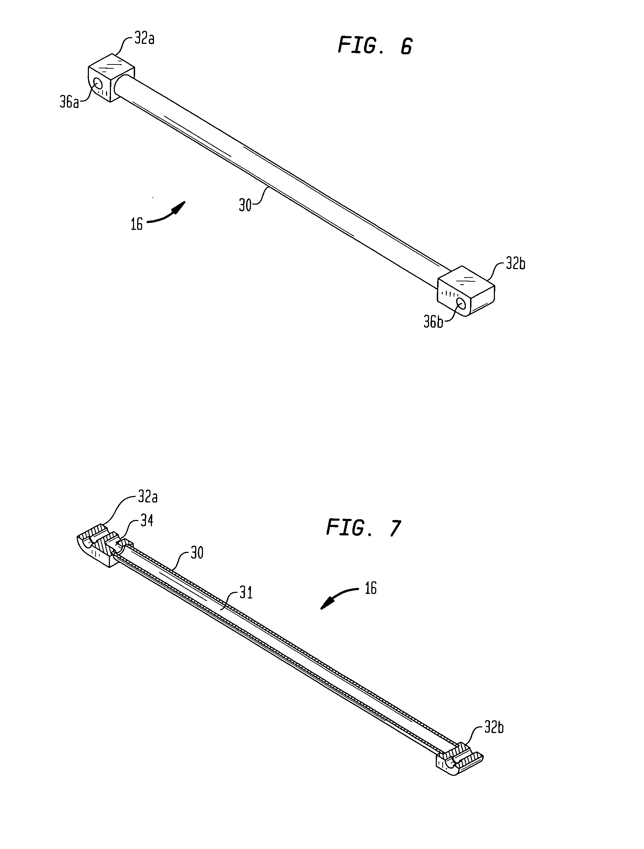

Referring now to Fig. 6, another perspective view of the purge gas diffusion device 16 of Fig. 5 is shown. In Fig. 6, securing channels 36a and 36b are shown from the reverse angle to illustrate those locations adapted to receive screws or other securing mechanisms in order to secure the entire purging gas diffusion device 16, including tubular portion 30, to the load lock.

It is contemplated that tubular portion 30 is constructed of a porous material, such that the purged gas may be diffused therethrough. In one embodiment, for example, the average pore size is substantially 100 microns, i.e., to prevent particles having an approximate diameter of 100 microns. More preferably, the average pore size for tubular portion 30 has less than 100 microns. However, any suitable pore size feasible for the particular operation is contemplated. The pores of tubular portion 30 may also serve to filter any purge gas as it enters the load lock.

Referring now to Fig. 7, a cross-sectional view of the purging gas diffusion device of Fig. 5 is shown. Purge gas diffusion device 16 is adapted to receive the purge gas such as nitrogen into purge gas inlet 34 located in end portion 32a. Nitrogen or other purge gas enters interior chamber 31 and is diffused through the pores of tubular portion 30. Because end portion 32b prevents purge gas from exiting through that end of tubular portion 30, as the purge gas fills purge gas diffusion device 16, purge gas will come through the pores and not through the ends of tubular portion 30.

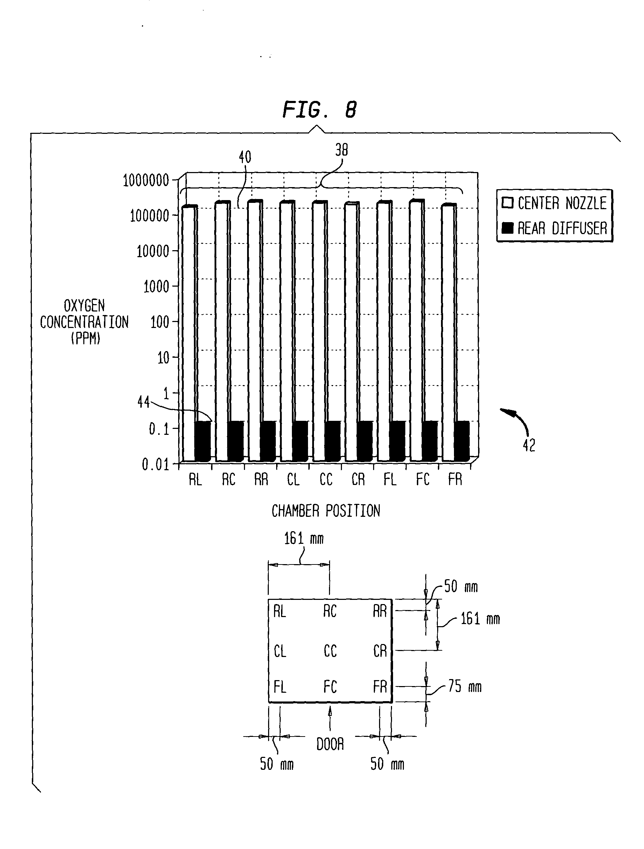

Fig. 8 is a graph illustrating oxygen concentration data taken from a purge optimization test. The test was conducted by comparing a nozzle to the purge gas dispersing device for completeness of purging of unwanted gaseous oxygen. In the first part of the test, a spray nozzle was placed at a central location of the load lock chamber 18. Purge gas was then sprayed through the nozzle. Oxygen concentration levels were then taken at nine locations within the load lock chamber, the locations being shown in the side legend. The locations correspond to the relative orientation positions in the load lock, with the front corresponding to the side by the atmospheric door, and with the rear corresponding to the side near the vacuum door. The locations represented are RL, RC, RR, CL, CC, CR, FL, FC and FR. They are defined as follows in a conventional manner.

| | |
|---|---|
| RL | rear left |
| RC | rear center |
| RR | rear right |
| CL | center left |
| CC | center center |
| CR | center right |
| FL | front left |
| FC | front center |
| FR | front right |

Each of the test locations were approximately 161 mm away from each other and offset between 50 mm and 75 mm from the interior wall of the load lock chamber. The readings for the center nozzle (collectively 38), that is, when the nozzle provides the purge gas in the center of the load lock chamber, reveal oxygen concentrations exceeding 100,000 ppm (40) for all nine locations within the load lock chamber.

In the next part of the experiment, a diffuser device was used and was placed in the rear (corresponding to the offset channel portion) of the load lock chamber. Purge gas was diffused through the rear diffuser and again oxygen concentration measurements were taken at the same locations in the load lock chamber. In this experiment, the rear diffuser readings (collectively 42) indicated oxygen concentrations of less than 0.1 PPM, for all nine chambers position locations as shown in the graph at 44. This represents a reduction in the oxygenation concentration in parts per million by a factor of six when using a porous diffuser at a rear of the load lock chamber and generating the purge gas front from that location. Other tests revealed oxygen concentration levels in the range from about .1 PPM to under 100,000 PPM.

A method for purging a load lock includes providing a load-lock having a vacuum door and an atmospheric door and defining a load-lock chamber, a purging gas diffusion device disposed in the load-lock chamber proximate the vacuum door and distal from the atmospheric door, the purging gas diffusion device including a plurality of pores. The method includes diffusing purge gas through the pores of the purging gas diffusing device; creating a purge gas flow within the load-lock chamber to remove ambient air having at least one ambient gas; and purging the load-lock with the purge gas to create an ambient gas concentration of the ambient gas.

The present invention has been described in terms of the preferred embodiment, and it is recognized that equivalents, alternatives, and modifications, aside from those expressly stated, are possible and within the scope of the appending claims.

For example, suitable flow rates of the purge gas, alternative materials for the purge gas diffusion device, and optimal load lock heights are to be considered to be part of the present invention.

## Claims

1. Purging apparatus comprising:
a load-lock having a vacuum door and an atmospheric door and defining a load-lock chamber; and
disposed in the load-lock chamber proximate the vacuum door and distal from the atmospheric door, means for diffusing a purging gas through the load-lock, said means including a porous section.

2. Apparatus according to Claim 1 wherein the load-lock chamber further defines a through-path portion extending from the vacuum door to the atmospheric door and an offset channel portion in communication with and offset from the through-path portion, and wherein the purging gas diffusion means is disposed substantially in the offset channel portion and does not extend substantially into the through-path portion.

3. Apparatus according to Claim 2 wherein the purging gas diffusion means is arranged to diffuse an inert purge gas.

4. Apparatus according to Claim 3 wherein the inert purge gas is selected from the group consisting of N (sub) 2, Ar and He.

5. Apparatus according to Claim 3 or Claim 4 wherein the inert gas is diffused to create a substantially laminar flow.

6. Apparatus according to any preceding claim wherein the purging gas diffusion means includes a hollow tubular member for receiving a purge gas and diffusing the purge gas through a porous section thereof.

7. Apparatus according to any preceding claim wherein the purging gas diffusion means is arranged to produce an oxygen gas concentration in the load-lock chamber that is less than 100,000PPM.

8. Apparatus according to any preceding claim wherein the purging gas diffusion means is arranged to produce an oxygen gas concentration in the load-lock chamber that is less than 0.1 PPM.

9. Apparatus according to any preceding claim, wherein the purging gas diffusion means is disposed substantially horizontal with respect to the load lock chamber.

10. Apparatus according to any preceding claim, wherein the purging gas diffusion means is positioned within the load-lock chamber to prevent obstruction of products passing through the load-lock chamber.

11. Apparatus according to any preceding claim wherein the purging gas diffusion means includes a purge gas inlet end portion connected to and in communication with a porous tubular portion such that, in use, the purge gas passes through the purge gas inlet end portion and into the porous tubular portion, and is then diffused through the pores and into the load-lock chamber.

12. Apparatus according to any preceding claim wherein the purging gas diffusion means is a substantially tubular frit.

13. Apparatus according to any preceding claim, wherein the purging gas diffusion means has an average pore size that is approximately 100 microns.

14. Apparatus according to any of Claims 1 to 12 wherein the purging gas diffusion means has an average pore size that is less than 100 microns.

15. Apparatus according to any preceding claim, wherein the purging gas diffusion means is arranged to filter the purge gas.

16. A load-lock purging system comprising purging apparatus according to any preceding claim, the purging gas diffusion means including pores for diffusing the purge gas therethrough in a purge flow that travels generally through the load-lock chamber in a purge flow direction from the vacuum door to the atmospheric door.

17. A load-lock purging system of Claim 16 wherein the load-lock chamber is capable of having an interior pressure that is substantially equal to a vacuum condition.

18. A load-lock purging system according to Claim 16 or Claim 17 wherein the purge flow is substantially a laminar flow.

19. Purging apparatus for a load-lock, the apparatus comprising means for diffusing a purge gas through the load-lock, said means comprising a porous section through which the purge gas enters the load-lock.

20. A method of purging a load-lock comprising:
providing a load-lock having a vacuum door and an atmospheric door and defining a load-lock chamber, a purging gas diffusion device disposed in the load-lock chamber proximate the vacuum door and distal from the atmospheric door, the purging gas diffusion device including a plurality of pores;
diffusing purge gas through the pores of the purging gas diffusing device;
creating a purge gas flow within the load-lock chamber to remove ambient air having at least one ambient gas; and
purging the load-lock with the purge gas to create an ambient gas concentration of the ambient gas.

21. A method according to Claim 20 wherein the oxygen gas concentration following purging of the load-lock chamber is less than .1 PPM.
